# EUROPÄISCHE PATENTSCHRIFT

(11) **EP 0 621 640 B1**
(45) Veröffentlichungstag und Bekanntmachung des Hinweises auf die Patenterteilung: **03.06.1998**
(21) Anmeldenummer: 94104769.8
(22) Anmeldetag: 25.03.1994
(51) Int. Cl.: H01L 29/08, H01L 29/10

(54) **Leistungshalbleiterbauelement**
Semiconductor power device
Dispositif de puissance à semi-conducteur

(30) Priorität: 22.04.1993 DE 4313170
(43) Veröffentlichungstag der Anmeldung: 26.10.1994
(73) Patentinhaber: ASEA BROWN BOVERI AG, 5400 Baden (CH)
(72) Erfinder: Bauer, Friedhelm, Dr., CH-3063 Ittigen (CH); Lilja, Klas, CH-5442 Fislisbach (CH)

(56) Entgegenhaltungen:
- EP-A- 0 330 122
- EP-A- 0 416 805
- EP-A- 0 430 133
- Shibib et al. IEEE Trans. El. Rev. ED-26, 6 (1979), p. 959
- De Castro et al. IEEE Trans. El. Rev. ED-31, 6 (1984), p. 785
- Amantea: IEEE Trans. El. Rev., ED-27, 7 (1980), p. 1231

## Beschreibung

### Technisches Gebiet

Die Erfindung bezieht sich auf das Gebiet der Leistungselektronik.

Sie geht aus von einem Leistungshalbleiterbauelement nach dem Oberbegriff des ersten Anspruchs.

### Stand der Technik

Ein Leistungshalbleiterbauelement wird beispielsweise als MCT im Artikel "Evolution of MOS-Bipolar Power Semiconductor Technology" (B.J. Baliga in Proceedings of the IEEE, Vol 76, No. 4, April 1988), als IGBT z.B. in der EP-A2-0 405 138 beschrieben und als GTO z.B. in der US 4,910,573.

Die der Anmeldung zugrunde liegende Problematik soll im folgenden anhand eines IGBT, wie er in der o.g. Europäischen Patentschrift beschrieben wird, näher erläutert werden.

Der in dieser Schrift beschriebene IGBT weist eine PT-IGBT (PT = punch through) Struktur auf. Er umfasst eine hochdotierte Stopschicht mit niedriger Trägerlebensdauer. Die n-Basis besteht aus einer epitaktisch gewachsenen Schicht, deren Dicke entsprechend der gewünschten Blokkierspannung gewählt wird. Im Bereich bis 1kV Blockierspannung ist diese IGBT-Struktur heute vorherrschend.

Für Hochspannungsanwendungen (z.B. 4.5 kV Sperrspannung) ist die oben dargestellte, konventionelle IGBT Struktur aus mehreren Gründen nicht geeignet:
- es steht bis heute keine Epitaxietechnologie zur Verfügung, um die Anforderungen an Defektdichte und Dotierungshomogenität für sehr hohe Blockierspannungen zu gewährleisten;
- niedrige Abschaltverluste können nur mit sehr kurzen Ladungsträgerlebensdauern erzielt werden; dies zieht jedoch eine für Hochspannungsanwendungen unakzeptable Erhöhung der Durchlassverluste nach sich.

Als Konsequenz daraus werden heute NPT (NPT = non punch through) IGBT Strukturen für den Bereich höherer Sperrspannungen (bis ca. 2 kV) den PT IGBTs vorgezogen. Zum Beispiel wird in der EP-A1-0 416 805 (entspricht dem Oberbegriff des Anspruchs 1) ausdrücklich von einem Punch-Through gewarnt. Eine solche NPT IGBT Struktur wird auch in der EP-A1-0 330 122 beschrieben. In jedem NPT-Leistungshalbleiterbauelement ist die Dicke des Halbleitersubstrats für die geforderte Sperrspannung immer stark überdimensioniert. Dadurch wird sichergestellt, dass das Feld auch im Sperrfall in sicherer Entfernung von dem p+ Anodenemitter bleibt und somit kein fataler Kurzschluss auftreten kann. Ein weiterer Grund für die starke Überdimensionierung liegt darin begründet, die Höhe der Tailströme und somit die Höhe der Abschaltverluste auf niedrigem Niveau zu halten. So ist bekannt, dass die Tailströme stark ansteigen, wenn man versucht, den Grad der Überdimensionierung der Substratdicke zu verkleinern. Der Anstieg der Tailströme wird auf eine Umverteilung des Plasmas in der quasineutralen Zone (vom anodenseitigen Ende der Raumladungszone bis zum p+ Anodenemitter) zurückgeführt.

Das Abklingen der Tailströme wird im wesentlichen von der Trägerlebensdauer bestimmt. Da die Abklingzeitkonstante im Normalfall zu lang ist, um hinreichend kleine Abschaltverluste zu erzielen, werden auf der Anodenseite Mittel vorgesehen, welche die Abklingzeitkonstante durch Ladungsträgerextraktion unterstützen. Dies kann, wie z.B. in der EP 0 330 122 beschrieben wird, mit Hilfe eines transparenten Emitters geschehen. Bei GTOs ist es zudem Stand der Technik, Anodenkurzschlüsse neben dem p+ Anodenemitter vorzusehen.

Der wesentliche Nachteil von NPT Leistungshalbleiterstrukturen für Hochspannungsanwendungen besteht in der unökonomischen Ausnutzung der Substratdicke. Ein typischer NPT GTO für 4.5 kV weist eine Dicke der n-Basiszone von 700 µm auf. Eine PT Version für die gleiche Blockierspannung würde hingegen nur etwa 400 µm benötigen. Die erheblich niedrigeren Durchlassverluste eine PT Bauelements können dahingehend verwendet werden, durch verkürzte Trägerlebensdauern stark reduzierte Abschaltverluste zu erreichen. Als Konsequenz wird eine signifikante Erhöhung der zulässigen Schaltfrequenz möglich.

Die Minimierung der Substratdicke ist auch für Leistungsdioden von ganz wesentlicher Bedeutung. Auf diese Weise kann mit Hilfe einer PT Struktur die Sperrverzugsladung und damit die Rückstromspitze auf ein Minimum reduziert werden. Allerdings ist von solchen Diodenstrukturen bekannt, dass es zu einem unerwünschten, scharfen Abriss des Diodenstroms am Ende der Ausräumphase kommt.

In der EP 0 430 133 (entspricht dem Oberbegriff des Anspruchs 1) wird eine Stopschicht mit einem mit Kurzschlüssen durchsetzten Anodenemitter vorgeschlagen. Wegen der vergleichsweise hohen Leitfähigkeit der Stopschicht fliesst aber der grösste Teil der von der Kathode kommenden Elektronen in die Anodenkurzschlüsse (bei der EP 0 430 133: mindestens 50% des Löcherstroms). Die p+ Anodenemitter sind dann zu stark vershortet, und der prinzipielle Vorteil der PT Struktur kommt wegen der hohen Durchlassspannung nicht zum Tragen. Man hat versucht, dies durch einen extrem kleinen Anteil von Anodenshorts zu verhindern. Nun aber wird die Ladungsträgerextraktion über die Shorts stark behindert. Wie oben erläutert wächst dann das Niveau der Tailströme mit der Konsequenz inakzeptabel hoher Abschaltverluste. Deshalb scheitert die praktische Ausführung eines PT Leistungshalbleiterbauelements bisher auch an der Verbindung von Stopschicht und Anodenshorts.

Die hier erläuterten Effekte treten sowohl beim eben diskutierten IGBT, sondern auch beim MCT und GTO auf. Bei der Diode tritt das Abrissverhalten des Stroms beim Abkommutieren in den Vordergrund.

### Darstellung der Erfindung

Aufgabe der vorliegenden Erfindung ist es deshalb, ein Leistungshalbleiterbauelement, insbesondere für hohe Sperrspannungen, anzugeben, bei welchem die Vorteile einer PT Struktur mit minimal dünnem Substrat gegenüber einem NPT Bauelement ohne die oben erläuterten Nachteile und Kompromisse ausgeschöpft werden können.

Insbesondere ist eine Anodenstruktur zu definieren, welche eine optimal bemessene Stopschicht zur anodenseitigen Begrenzung des elektrischen Feldes in Kombination mit Mitteln zur maximalen, anodenseitigen Extraktion von Ladungsträgern während des Abschaltvorgangs ermöglicht. Die Anodenstruktur soll so ausgelegt werden, dass kein Stromabriss auftritt.

Diese Aufgabe wird bei einem Leistungshalbleiterbauelement der eingangs genannten Art durch die Merkmale des ersten und des fünften Anspruchs gelöst.

Kern der Erfindung ist es also, Mittel vorzusehen, welche es ermöglichen, die Dicke des Leistungshalbleiterbauelements zu verringern und gleichzeitig die Verluste minimal zu halten. Eine Verringerung der Halbleitersubstratdicke ist nur durch eine anodenseitige Begrenzung des Feldes mit Hilfe einer Stopschicht möglich. Die Ausdehnung ins Substrat und der Dotierstoffgradient dieser Stopschicht bestimmen das Abrissverhalten des Stroms. Bei geeigneter Auslegung kann das Feld noch partiell in den vordersten Teil der Stopschicht eindringen.

Die Vermeidung der Tailströme beim erfindungsgemässen Halbleiterbauelement wird durch die Kombination der Stopschicht mit einem transparenten Emitter erreicht. Durch die Variation der Ausdehnung der Stopschicht, ihrer maximalen Dotierungskonzentration und ihres Dotierungsgradienten einerseits, sowie durch Einstellung von Dotierstoffkonzentration und Tiefe des transparenten Emitters andererseits kann ein breites Spektrum von Abschaltstromverläufen über die Zeit eingestellt werden (vom abrupten Stromabriss mit minimalen Abschaltverlusten bis zum weichen Abklingen des Stroms mit nur geringfügig höheren Abschaltverlusten). Diese Kombination sorgt für herausragende Eigenschaften der PT Struktur im Vergleich mit einem konventionellen NPT Bauelement: Der Verlauf der Abschaltverluste des PT Bauelements über der Anodenspannung ist linear, während ein NPT Bauelement durch einen angenähert quadratischen Zusammenhang gekennzeichnet ist.

Unter einem transparenten Emitter wird im folgenden eine anodenseitige Emitterschicht verstanden, welche so gestaltet ist, dass ein signifikanter Anteil des Gesamtstroms die Anodenmetallisierung des Bauelements als Elektronenstrom verlässt. Diesen in % des Gesamtstroms angegebenen Elektronenstrom bezeichnet man als Emittertransparenz. Technologisch kann die Emittertransparenz durch Tiefe und Randkonzentration des p+ Anodenemitters in weiten Grenzen eingestellt werden. Von technischer Bedeutung sind p+ Anodenemitter mit einer Transparenz von 50% und mehr. Die Kombination eines transparenten Emitters mit einer Stopschicht hat den Effekt, dass die Raumladungszone während des Abschaltvorgangs in die Stopschicht eindringt und die Ladung durch den transparenten Emitter aus dem Bauelement schiebt. Als Folge davon fällt der Strom in sehr kurzer Zeit auf Null ab, ohne die bei konventionellen Strukturen typischen, langsam abfallenden Tailströme. Dadurch werden die Abschaltverluste minimiert.

Die Stopschicht wird aus folgendem Grund benötigt: In der Stopschicht stagniert das Eindringen der Raumladungszone beim Aufbau der Anodenspannung. Es verbleibt eine kleine Zone innerhalb der Stopschicht, welche fast feldfrei ist. In diesem Volumen befindet sich also nur ein kleiner Rest der gespeicherten Ladung. Da nur ein sehr kleines Feld vorhanden ist, um diese Ladung zum transparenten Emitter zu befördern, verschwindet die Ladung grösstenteils durch die langsame Rekombination. Vergrössert man nun die Dicke der Stopschicht und damit den verbleibenden Ladungsrest, so wird das Abklingen des Stroms zunehmend weicher erfolgen.

Die soeben beschriebenen Effekte können für IGBTs, MCTs, GTOs und Dioden ausgenützt werden. Es werden deshalb für jedes dieser Bauteile Ausführungsbeispiele angegeben.

Bei der Diode ist die Stopschicht nicht auf der Anodenseite, sondern auf der Kathodenseite angeordnet, denn bei der Diode wechselt der Strom bei Übergang Leiten-Sperren ja bekanntlich die Richtung ("Reverse Recovery"). Wie vorhin ausgeführt verhindert die kathodenseitige Stopschicht bei der Diode ein abruptes Abreissen des Stroms am Ende der Reverse Recovery Phase. Der transparente p+ Anodenemitter kann auch bei der Diode vorteilhaft mit der kathodenseitigen Stopschicht kombiniert werden. Die Verwendung beider Mittel erlaubt die Minimierung der Diodendicke bei gleichzeitig schwacher Injektion von der Anodenseite. Als Folge wird die Sperrverzugsladung der Diode minimal; bekanntlich ist dies der effektivste Weg zur Reduktion der Rückstromspitze. Die kathodenseitige Stopschicht stellt sicher, dass das Abklingen des Diodenrückstroms weich erfolgt.

Bei nahezu maximaler Emittertransparenz wird der Durchlasswiderstand für praktische Anwendungen zu hoch. Diesem Nachteil kann aber auf einfache Weise abgeholfen werden, indem der transparente Emitter mit p+ Emitterinseln durchsetzt wird. Diese spezielle Ausführungsform entspricht einer weiteren, bevorzugten Ausführungsform und kann sowohl bei Dioden als auch bei Schaltern zur Anwendung kommen.

Weitere Ausführungsbeispiele ergeben sich aus den Unteransprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1a**: Eine erfindungsgemässe Anodenstruktur für einen Halbleiterschalter mit Stopschicht und transparentem Emitter;
- **Fig. 1b**: Eine erfindungsgemässe Anodenstruktur für einen Halbleiterschalter mit Stopschicht, transparentem Emitter und p+ Emitterinseln;
- **Fig. 1c**: Eine erfindungsgemässe Anodenstruktur für einen Halbleiterschalter mit Stopschicht, transparentem Emitter und einem p+ Emittergebiet, welches unter dem Randabschluss angeordnet ist;
- **Fig. 2a**: Eine Kathodenstruktur eines IGBTs;
- **Fig. 2b**: Eine Kathodenstruktur eines MCTs;
- **Fig. 2c**: Eine Kathodenstruktur eines GTOs; und
- **Fig. 3a**: Eine erfindungsgemässe Struktur einer Diode nach einem ersten Ausführungsbeispiel;
- **Fig. 3b**: Eine erfindungsgemässe Struktur einer Diode nach einem zweiten Ausführungsbeispiel.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

Ein erfindungsgemässes Leistungshalbleiterbauelement umfasst ein Halbleitersubstrat (1), in welches mehrere Schichten unterschiedlicher Dotierung eindiffundiert sind. Diese Schichten werden durch zwei Hauptflächen (2 und 3) begrenzt. Die erste Hauptfläche (2) ist einer Kathode (4) zugeordnet, die zweite (3) einer Anode (5). Anode (5) bzw. Kathode (4) werden durch entsprechende Metallisierungen (10 bzw. 22) gebildet.

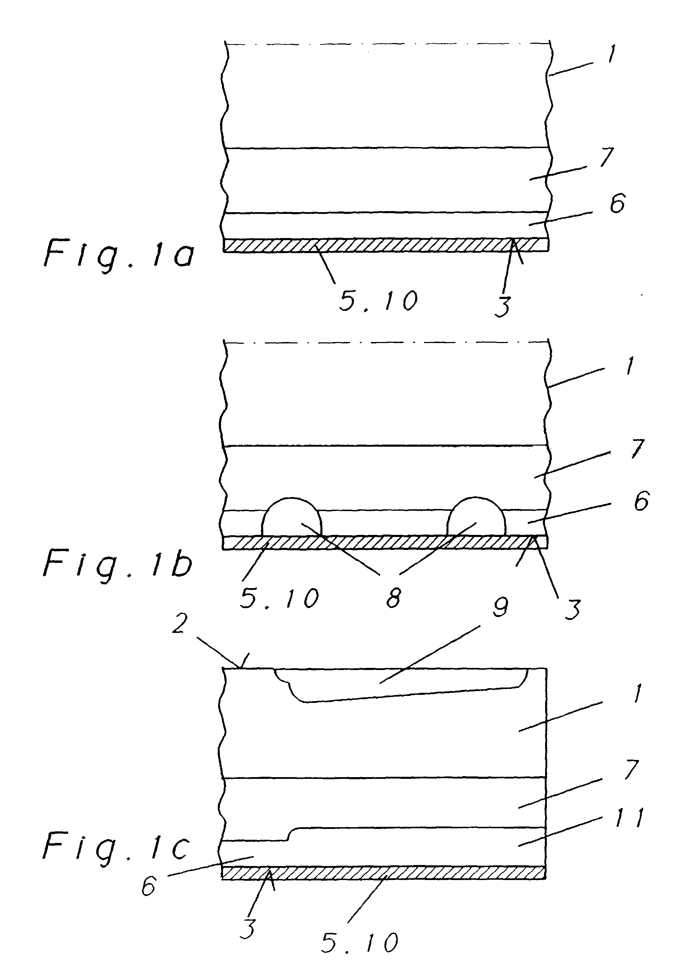

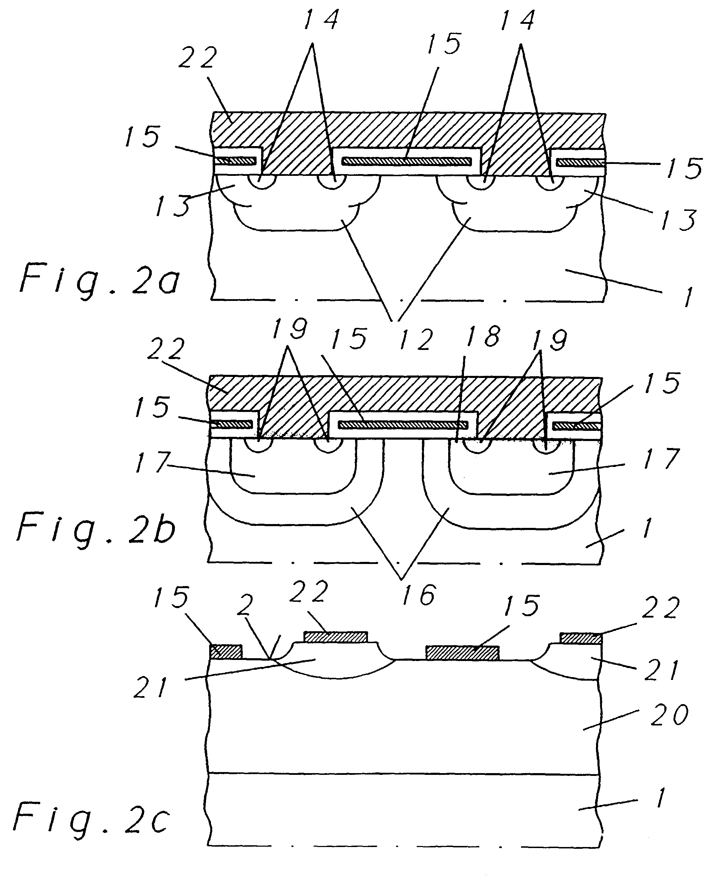

Die kathodenseitigen Strukturen für Halbleiterschalter wie IGBTs, MCTs und GTOs sind in den Figuren 2a-c dargestellt, die anodenseitigen in den Figuren 1a-c. Die kathodenseitigen Strukturen können dabei mit den anodenseitigen der Figuren 1a,b kombiniert werden, indem sie entlang der strichpunktierten Linie aneinander gefügt werden. Ein erfindungsgemässes Halbleiterbauelement ergibt sich auch, wenn eine Kombination der Figuren 2a-c und 1a am linken Rand von Figur 1c angefügt wird.

Figur 1a zeigt eine erfindungsgemässe Anodenstruktur. Sie besteht aus einer Anodenmetallisierung (10), einem transparenten Emitter (6) und einer Stopschicht (7). Nach der Stopschicht folgt das Halbleitersubstrat (1), welches n-dotiert ist. Im Fall eines IGBT, MCT oder eines GTO stellt das Halbleitersubstrat (1) gleichzeitig die n-Basis dar. Der transparente Emitter (6) ist vorzugsweise p+ dotiert und weist z.B. eine Tiefe von ca. 1.2 µm und eine Dotierung von 10¹⁸ cm⁻³ auf. Die darauf folgende Stopschicht (7) ist n dotiert, vorzugsweise höher als das Halbleitersubstrat (1). Als Richtwerte dienen die folgenden Angaben: Tiefe mehr als ca. 30 µm, Dotierung mehr als ca. 3*10¹⁶ cm⁻³. Unter Zuhilfenahme eines Epitaxieverfahrens können aber auch wesentlich tiefere Stopschichten erzeugt werden.

Die Wirkung der Kombination von transparentem Emitter und Stopschicht ist die folgende:

Beim Abschalten z.B. einer geklemmten, induktiven Last ohne passive Schutzbeschaltung und gegen eine Batteriespannung von 2 kV dringt das Feld in die Stopschicht ein und schiebt die Ladung durch den transparenten Emitter aus dem Bauelement. Folglich fällt der Strom in sehr kurzer Zeit auf Null ab ohne die sonst üblichen, langsam abfallenden Tailströme. Tailströme würden nur auftreten, falls die Raumladungszone nicht bis in die Stopschicht reichte (z.B. bei kleinerer Batteriespannung). Durch das Fehlen der Tailströme werden die Schaltverluste erheblich verkleinert.

In der Stopschicht stagniert das Eindringen der Raumladungszone beim Aufbau der Anodenspannung. Dadurch entsteht ein beinahe feldfreier Raum, in welchem ein Rest der gespeicherten Ladung verbleibt. Um diese Ladung zum transparenten Emitter zu befördern ist somit nur ein sehr kleines Feld vorhanden. Deshalb verschwindet die Ladung grösstenteils durch Rekombination. Dadurch klingt der Strom weich ab. Je dicker die Stopschicht gemacht wird, desto weicher klingt also der Strom ab. Das Verhältnis von Ladungsextraktion zu Rekombination kann durch den Grad der Emittertransparenz beeinflusst werden. Durch eine Reduktion der Transparenz, z.B. durch Erhöhung der p+ Randkonzentration, steigt der Anteil der Tailströme und gleichzeitig steigen auch die Schaltverluste.

Die oben beschriebene Wirkung tritt bei der einfachsten Form der erfindungsgemässen Anodenstruktur auf, welche in Figur 1a dargestellt ist. Entlang der strich-punktierten Linie können die Kathodenstrukturen von IGBTs, MCTs oder GTOs angesetzt werden. Diese Kathodenstrukturen sind in den Figuren 2a-c dargestellt.

Figur 2a zeigt eine Kathodenstruktur eines IGBTs. Diese umfasst ein n-dotiertes Halbleitersubstrat (1), auch n-Basis genannt, sowie darin eindiffundierte IGBT-Strukturen. Die IGBT-Strukturen ihrerseits umfassen einen p+ Kollektor (12), eine p-Wanne (13) und eine n+ Source (14). Über der kathodenseitigen Hauptfläche ist eine Gateelektrode (15) isoliert angeordnet. Mittels Anlegen einer Spannung an die Gateelektrode (15) kann der Stromfluss zwischen Kathode (4) und Anode (5) in bekannter Weise ein- und ausgeschaltet werden.

Figur 2b zeigt eine Kathodenstruktur eines MCTs. Wiederum wird von einem n-dotierten Halbleitersubstrat (1) ausgegangen. In Richtung der Kathode folgen aufeinander: eine p-Basis (16), ein n-Emitter (17), ein Kanalgebiet (18) ein p Shortgebiet (19). Über der kathodenseitigen Hauptfläche (2) und von einem MCT-Gebiet zum benachbarten reichend ist wiederum eine isolierte Gateelektrode (15) angeordnet. Mittels Anlegen einer Spannung an diese Gateelektrode lässt sich der Stromfluss von der Anode (5) zur Kathode (4) in bekannter Weise ein- und ausschalten.

Figur 2c schliesslich zeigt eine Kathodenstruktur eines GTOs. Wiederum ist ein n-dotiertes Halbleitersubstrat (1) vorhanden. Auf das Halbleitersubstrat (1) folgt gegen die Kathode (4) hin eine p-Basis (20), welche stellenweise an die kathodenseitige Oberfläche (2) dringt und an diesen Stellen mit einer Gateelektrode (15) in Verbindung steht. In der kathodenseitigen Oberfläche (2) ist eine Mehrzahl von n-dotierten Kathodengebieten (21) eindiffundiert. Wird das Gate (15) mit einem Steuerstrom beaufschlagt, kann der Strom zwischen Anode (5) und Kathode (4) in bekannter Weise ein- bzw. ausgeschaltet werden.

Die Kathodenstrukturen nach den Figuren 2a-c können nun mit der Anodenstruktur nach Figur 1a kombiniert werden, so dass erfindungsgemässe IGBTs, MCTs oder GTOs resultieren.

Um den Strom steiler abschalten zu können, möchte man den p+ Emitter (6) immer transparenter machen, d.h. niedriger dotieren. Dadurch wird der Durchlasswiderstand aber für praktische Anwendungen zu hoch. Diesem Umstand kann nun abgeholfen werden, indem der transparente Emitter mit p+ Emitterinseln (8) durchsetzt wird. Eine solche Anodenstruktur ist in Figur 1b dargestellt. Sie kann für IGBT, MCT und GTO eingesetzt werden. Die Tiefe dieser Emitterinseln beträgt beispielsweise 5 µm, deren Randkonzentration 10¹⁹ cm⁻³. Durch solche Emitterinseln sinkt der Durchlasswiderstand wieder ab. Ein weiterer Vorteil liegt darin, dass die Spannungsrate dV/dt effektiv begrenzt wird. Der flächenmässige Anteil der Inseln an der Gesamtfläche der Anode kann dabei recht gering gewählt werden.

In Figur 1c ist eine weitere bevorzugte Anodenstruktur eines erfindungsgemässen Halbleiterbauelements dargestellt. Statt einzelner p+ Emitterinseln (8) ist ein zusammenhängendes p+ Gebiet (11) vorhanden, welches in Linie unter dem Randabschluss (9) der kathodenseitigen Hauptfläche (2) angeordnet ist. Der in Figur 1c dargestellte Ausschnitt des Halbleiterbauelements stellt also den Rand des Bauelements dar. An den linken Rand von Figur 1c kann nun zum Beispiel eine Anodenstruktur nach Figur 1a und eine Kathodenstruktur nach den Figuren 2a-c angefügt werden. Dadurch erhält man ein Halbleiterbauelement, insbesondere einen IGBT, MCT oder GTO, mit einem nicht transparenten p+ Emittergebiet (11) unter dem Randabschluss (9). Als Randabschluss (9) kommen die bekannten Strukturen in Frage. Besonders bevorzugt wird ein planarer Randabschluss (9), wie er in Figur 1c dargestellt ist.

Die Wirkung der eben beschriebenen Anodenstruktur ist derjenigen mit Emitterinseln (8) ähnlich. Nebst der dV/dt-Begrenzung weist die Anordnung nach Figur 1c jedoch eine verbesserte Ladungsträgerextraktion auf. Denn der transparente Emitter (6) deckt sich mit der aktiven, emittierenden Kathodenfläche des Bauelements. Daraus ergeben sich geringere Abschaltverluste.

Die Wirkung des p+ Gebietes (11) unterhalb des Randabschlusses kommt einer dV/dt-Begrenzung durch einen separaten Snubberkondensator gleich. Ein weiterer Vorteil dieser in Figur 1c gezeigten Struktur besteht demgemäss darin, dass die Snubberkondensatoren zumindest verkleinert, u.U. sogar ganz weggelassen werden können.

Im folgenden wird noch auf die spezielle Situation bei der Diode eingegangen. Auch Dioden müssen bezügliche ihrer Verluste optimiert werden. Deshalb sind auch hier punch through Strukturen mit minimaler Dicke anzustreben. Solche Dioden weisen aber einen abrupten Stromabriss am Ende der Reverse Recovery Phase auf. Dies kann selbst bei kleinsten Induktivitäten zu untolerierbaren Spannungsspitzen führen. Deshalb wurden bis jetzt lieber nicht optimierte, in der Dicke überdimensionierte Dioden verwendet.

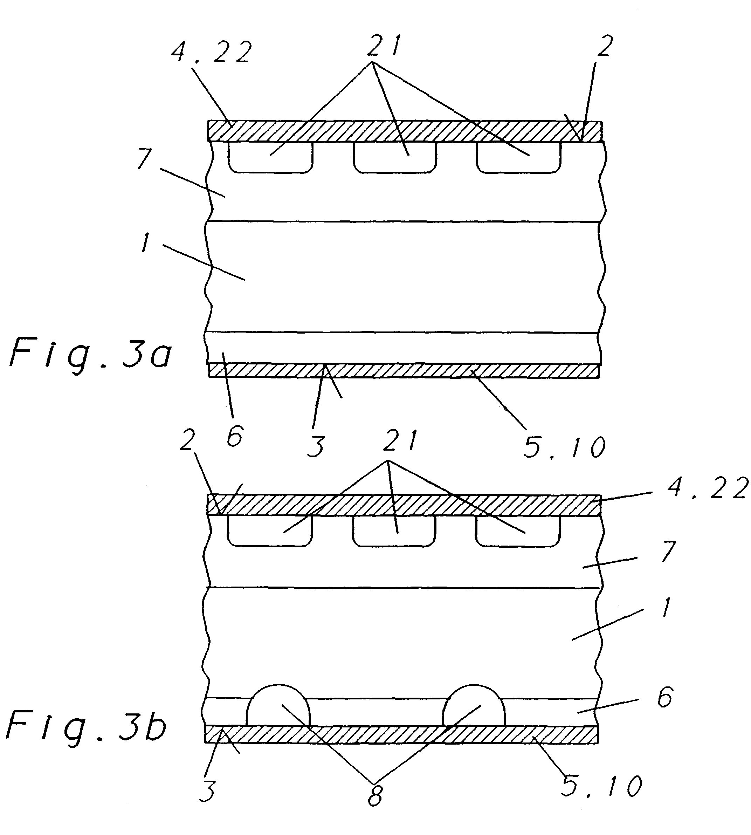

Aufgrund der Umkehrung des Stroms muss die erfindungsgemässe Stopschicht bei Dioden auf der Kathodenseite eingefügt werden. Figur 3a zeigt die entsprechende Situation. Nach der Anode (5), welche durch eine Anodenmetallisierung (10) gebildet wird, folgt der transparente p+ Emitter (6), das n-dotierte Halbleitersubstrat (1), die n dotierte Stopschicht (7) sowie eine Anzahl von n+ Kathodengebieten (21).

Die Wirkung des transparenten Emitters (6) und der Stopschicht (7) entspricht im wesentlichen derjenigen der oben beschriebenen Schalter. Ebenso ist der Einsatz von p+ Emitterinseln (8) von Vorteil. Ein Ausführungsbeispiel mit einer solchen Struktur ist in Figur 3b dargestellt.

Insgesamt steht also mit der Erfindung ein Leistungshalbleiterbauelement für hohe Sperrspannungen zur Verfügung, welches problemlos dünner ausgeführt werden kann und bezüglich Verluste optimiert ist.

### Bezeichnungsliste

- 1: Halbleitersubstrat
- 2: erste Hauptfläche
- 3: zweite Hauptfläche
- 4: Kathode
- 5: Anode
- 6: Transparenter Emitter
- 7: Stopschicht
- 8: p+ Emitterinseln
- 9: Randabschluss
- 10: Anodenmetallisierung
- 12: p+ Kollektor
- 11: p+ Emittergebiet
- 13: p-Wanne
- 14: n+ Source
- 15: Gateelektrode
- 16: p-Basis
- 17: n-Emitter
- 18: Kanalgebiet
- 19: p-Shortgebiet
- 20: p-Basis
- 21: n-Kathode
- 22: Kathodenmetallisierung

## Patentansprüche

1. Leistungshalbleiterbauelement, insbesondere für hohe Sperrspannungen, umfassend
a) ein n-dotiertes Halbleitersubstrat (1), in welches zwischen einer ersten Hauptfläche (2) und einer zweiten Hauptfläche (3) mehrere n- oder p-dotierte Schichten eindiffundiert sind;
b) eine Kathode (4), welche der ersten Hauptfläche (2) zugeordnet ist und durch eine erste Metallisierung (22) gebildet wird, sowie eine Anode (5), welche durch eine die zweite Hauptfläche (3) bedeckende, zweite Metallisierung (10) gebildet wird; wobei
c) die Schichten, von der zweiten Hauptfläche (3) her gesehen, einen p-dotierten Anoden-Emitter (6) und daran angrenzend eine n-dotierte, an das Halbleitersubstrat (1) grenzende Stopschicht (7), die eine höhere Ladungsträgerkonzentration aufweist als das Halbleitersubstrat (1), umfassen;
dadurch gekennzeichnet, dass
d) der Anoden-Emitter (6) als transparenter Emitter ausgeführt ist und dessen Tiefe und Ladungsträgerkonzentration (6) so gewählt sind, dass mindestens 50% eines durch den Emitter (6) fliessenden Gesamtstromes von Elektronen getragen wird.

2. Leistungshalbleiterbauelement nach Anspruch 1, dadurch gekennzeichnet, dass
a) von der kathodenseitigen Hauptfläche (2) eine Mehrzahl von IGBT-Strukturen mit einem p+ Kollektor (12), einer p-Wanne (13) und einer n+ Source (14) eindiffundiert ist; und
b) über der kathodenseitigen Hauptfläche und zwischen zwei IGBT-Strukturen eine Gateelektrode (15) isoliert vorgesehen ist.

3. Leistungshalbleiterbauelement nach Anspruch 1, dadurch gekennzeichnet, dass
a) von der kathodenseitigen Hauptfläche (2) eine Mehrzahl von MCT-Strukturen mit einer p-Basis (16), einem n-Emitter (17), einem Kanalgebiet (18) und einem p-Shortgebiet (19) eindiffundiert ist; und
b) über der kathodenseitigen Hauptfläche (2) und zwischen zwei MCT-Strukturen eine Gateelektrode (15) isoliert vorgesehen ist.

4. Leistungshalbleiterbauelement nach Anspruch 1, dadurch gekennzeichnet, dass
a) von der kathodenseitigen Hauptfläche (2) eine p-Basis (20) und eine Mehrzahl von n-Kathodengebieten (21) eindiffundiert sind, wobei
b) die Kathodengebiete (21) an die ersten Metallisierung (22) angrenzen.

5. Leistungshalbleiterbauelement, insbesondere für hohe Sperrspannungen, umfassend
a) ein n-dotiertes Halbleitersubstrat (1), in welches zwischen einer ersten Hauptfläche (2) und einer zweiten Hauptfläche (3) mehrere n- oder p-dotierte Schichten eindiffundiert sind;
b) eine Kathode (4), welche der ersten Hauptfläche (2) zugeordnet ist und durch eine erste Metallisierung (22) gebildet wird, sowie eine Anode (5), welche durch eine die zweite Hauptfläche (3) bedeckende, zweite Metallisierung (10) gebildet wird; wobei
c) die Schichten, von der zweiten Hauptfläche (3) her gesehen, einen p-dotierten Anoden-Emitter (6), daran angrenzend das Halbleitersubstrat (1) und an dieses angrenzend eine n-dotierte Stopschicht (7), die eine höhere Ladungsträgerkonzentration aufweist als das Halbleitersubstrat (1), umfassen,
d) die Stopschicht zwischen dem Halbleitersubstrat (1) und der kathodenseitigen Hauptfläche (2) angeordnet ist, und dass
e) die Stopschicht eine Mehrzahl von n+ Kathodengebieten (21) aufweist, und wobei
f) der Anoden-Emitter (6) als transparenter Emitter ausgeführt ist und dessen Tiefe und Ladungsträgerkonzentration (6) so gewählt sind, dass mindestens 50% eines durch den Emitter (6) fliessenden Gesamtstromes von Elektronen getragen wird.

6. Leistungshalbleiterbauelement nach einem der Ansprüche 2-5, dadurch gekennzeichnet, dass der transparente p-Anoden-Emitter (6) mit einer Vielzahl von p+ Emitterinseln (8), welche höher dotiert sind als der transparente Anoden-Emitter (6), durchsetzt ist.

7. Leistungshalbleiterbauelement nach einem der Ansprüche 2-6, dadurch gekennzeichnet, dass
a) das Halbleiterbauelement einen Randabschluss (9) aufweist, und
b) der transparente Anoden-Emitter (6) unter dem Randabschluss in ein p+ Gebiet (11) übergeht.

8. Leistungshalbleiterbauelement nach Anspruch 7, dadurch gekennzeichnet, dass das p+ Gebiet (11) höher dotiert ist als der transparente Anoden-Emitter (6) und weiter in die Stopschicht (7) reicht als der transparente Anoden-Emitter (6).

9. Leistungshalbleiterbauelement nach Anspruch 7, dadurch gekennzeichnet, dass der Randabschluss (9) als planarer Randabschluss ausgeführt ist.

10. Leistungshalbleiterbauelement nach einem der vorangehenden Ansprüche, dadurch gekennzeichnet, dass der transparente Anoden-Emitter (6) eine Tiefe von 1.2 µm und eine Ladungsträgerkonzentration von 10¹⁸ cm⁻³ aufweist.

11. Leistungshalbleiterbauelement nach einem der vorangehenden Ansprüche, dadurch gekennzeichnet, dass die Stopschicht (7) eine Tiefe von mehr als 30 µm und eine Ladungsträgerkonzentration von mehr als 3*10¹⁶ cm⁻³ aufweist.

## Claims

1. Power semiconductor component, in particular for high blocking voltages, comprising
a) an n-doped semiconductor substrate (1) into which a number of n- or p-doped layers are diffused between a first main area (2) and a second main area (3) ;
b) a cathode (4) which is allocated to the first main area (2) and is formed by a first metallization (22), and an anode (5) which is formed by a second metallization (10) covering the second main area (3); wherein
c) the layers, seen from the second main area (3), comprise a p-doped anode emitter (6) and, adjoining the latter, an n-doped stop layer (7) adjoining the semiconductor substrate (1), which stop layer (7) exhibits a greater charge carrier concentration than the semiconductor substrate (1);
characterized in that
d) the anode emitter (6) is constructed as transparent emitter and its depth and charge carrier concentration are selected in such a manner that at least 50% of a total current flowing through the emitter (6) is carried by electrons.

2. Power semiconductor component according to Claim 1, characterized in that
a) a plurality of IGBT structures having a p+-type collector (12), a p-type tub (13) and an n+-type source (14) is diffused in from the cathode-side main area (2) ; and
b) a gate electrode (15) is provided insulated above the cathode-side main area and between two IGBT structures.

3. Power semiconductor component according to Claim 1, characterized in that
a) a plurality of MCT structures having a p-type base (16), an n-type emitter (17), a channel region (18) and a p-type shorting region (19) is diffused in from the cathode-side main area (2); and
b) a gate electrode (15) is provided insulated above the cathode-side main area (2) and between two MCT structures.

4. Power semiconductor component according to Claim 1, characterized in that
a) a p-type base (20) and a plurality of n-type cathode regions (21) are diffused in from the cathode-side main area (2),
b) the cathode regions (21) adjoin the first metallization (22).

5. Power semiconductor component, in particular for high blocking voltages, comprising
a) an n-doped semiconductor substrate (1) into which a number of n- or p-doped layers are diffused between a first main area (2) and a second main area (3) ;
b) a cathode (4) which is allocated to the first main area (2) and is formed by a first metallization (22), and an anode (5) which is formed by a second metallization (10) covering the second main area (3) ; wherein
c) the layers, seen from the second main area (3), comprise a p-doped anode emitter (6), adjoining the latter, the semiconductor substrate (1), and, adjoining the latter, an n-doped stop layer (7) which exhibits a greater charge carrier concentration than the semiconductor substrate (1);
d) the stop layer is arranged between the semiconductor substrate (1) and the cathode-side main area (2), and
e) the stop layer exhibits a plurality of n+-type cathode regions (21), and wherein
f) the anode emitter (6) is constructed as transparent emitter and its depth and charge carrier concentration are selected in such a manner that at least 50% of a total current flowing through the emitter (6) is carried by electrons.

6. Power semiconductor component according to one of Claims 2 - 5, characterized in that the transparent p-type anode emitter (6) is interspersed with a multiplicity of p+-type emitter islands (8) which have higher doping than the transparent anode emitter (6).

7. Power semiconductor component according to one of Claims 2 - 6, characterized in that
a) the semiconductor component exhibits an edge termination (9), and
b) the transparent anode emitter (6) changes into a p+-type region (11) underneath the edge termination.

8. Power semiconductor component according to Claim 7, characterized in that the p+-type region (11) has higher doping than the transparent anode emitter (6) and extends further into the stop layer (7) than the transparent anode emitter (6).

9. Power semiconductor component according to Claim 7, characterized in that the edge termination (9) is constructed as planar edge termination.

10. Power semiconductor component according to one of the preceding claims, characterized in that the transparent anode emitter (6) exhibits a depth of 1.2 µm and a charge carrier concentration of 10¹⁸ cm⁻³.

11. Power semiconductor component according to one of the preceding claims, characterized in that the stop layer (7) exhibits a depth of more than 30 µm and a charge carrier concentration of more than 3*10¹⁶ cm⁻³.

## Revendications

1. Dispositif à semi-conducteur de puissance, en particulier pour tensions de blocage élevées, comprenant :
a) un substrat semi-conducteur (1) à dopage n, auquel plusieurs couches à dopage n ou p ont été intégrées par diffusion entre une première surface principale (2) et une seconde surface principale (3);
b) une cathode (4), qui est affectée à la première surface principale (2) et est formée d'une première métallisation (22); ainsi qu'une anode (5) qui est formée d'une seconde métallisation (10) recouvrant la seconde surface principale (3);
c) les couches, vues à partir de la seconde surface principale (3), qui comprennent un émetteur anodique (6) à dopage p et une couche d'arrêt (7) à dopage n, qui s'y raccorde et est contiguë au substrat semi-conducteur (1), ladite couche d'arrêt ayant une concentration en porteurs de charge plus élevée que celle du substrat semi-conducteur (1);
caractérisé en ce que
d) l'émetteur anodique (6) se présente sous la forme d'un émetteur transparent dont la profondeur et la concentration en porteurs de charge sont sélectionnées de telle sorte qu'au moins 50% d'un courant total s'écoulant à travers l'émetteur (6) soient portés par des électrons.

2. Dispositif de puissance à semi-conducteur selon la revendication 1, caractérisé en ce que
a) une pluralité de structures IGBT ayant un collecteur p+ (12), une auge p (13) et une source n+ (14) sont intégrées par diffusion à la surface principale côté cathode (2), et
b) une électrode de grille (15) est disposée, isolée, sur la surface principale côté cathode et entre deux structures IGBT.

3. Dispositif à semi-conducteur de puissance selon la revendication 1, caractérisé en ce que
a) une pluralité de structures MCT ayant une base p (16), un émetteur n (17), une zone de canal (18) et une zone de court-circuit p (19) sont intégrées par diffusion à la surface principale côté cathode (2); et
b) une électrode de grille (15) est disposée, isolée, sur la surface principale côté cathode (2) et entre deux structures MCT.

4. Dispositif à semi-conducteur de puissance selon la revendication 1, caractérisé en ce que
a) une base p (20) et une pluralité de zones cathodiques n (21) sont intégrées par diffusion à la surface principale côté cathode (2),
b) les zones cathodiques (21) étant contiguës à la première métallisation (22).

5. Dispositif à semi-conducteur de puissance, en particulier pour tensions de blocage élevées, comprenant :
a) un substrat semi-conducteur (1) à dopage n, auquel plusieurs couches à dopage n ou p sont intégrées par diffusion entre une première surface principale (2) et une seconde surface principale (3);
b) une cathode (4), qui est affectée à la première surface principale (2) et est formée par une première métallisation (22), ainsi qu'une anode (5), qui est formée par une seconde métallisation recouvrant la seconde surface principale (3);
c) les couches, vues à partir de la seconde surface principale (3), comprenant un émetteur anodique (6) à dopage p, le substrat semi-conducteur (1) qui s'y raccorde et, contiguë à celui-ci, une couche d'arrêt (7) à dopage n, qui a une concentration en porteurs de charge plus élevée que celle du substrat semi-conducteur (1),
d) la couche d'arrêt étant disposée entre le substrat semi-conducteur (1) et la surface principale côté cathode (2),
e) la couche d'arrêt présentant une pluralité de zones cathodiques n+ (21), et
f) l'émetteur anodique (6) se présentant sous la forme d'un émetteur transparent dont la profondeur et la concentration en porteurs de charge sont sélectionnées de telle sorte qu'au moins 50% d'un courant total s'écoulant à travers l'émetteur (6) soient portés par des électrons.

6. Dispositif à semi-conducteur de puissance selon l'une quelconque des revendications 2 à 5, caractérisé en ce que l'émetteur anodique p transparent (6) contient une série d'îlots émetteurs p+ (8) qui sont plus fortement dopés que l'émetteur anodique transparent (6).

7. Dispositif à semi-conducteur de puissance selon l'une quelconque des revendications 2 à 6, caractérisé en ce que
a) le dispositif à semi-conducteur présente un bord terminal (9), et
b) l'émetteur anodique transparent (6) sous le bord terminal se fond dans une zone p+ (11).

8. Dispositif à semi-conducteur de puissance selon la revendication 7, caractérisé en ce que la zone p+ (11) est plus fortement dopée que l'émetteur anodique transparent (6) et s'étend plus loin dans la couche d'arrêt (7) que l'émetteur anodique transparent (6).

9. Dispositif à semi-conducteur de puissance selon la revendication 7, caractérisé en ce que le bord terminal (9) se présente sous la forme d'une bord terminal planar.

10. Dispositif à semi-conducteur de puissance selon l'une quelconque des revendications précédentes, caractérisé en ce que l'émetteur anodique transparent (6) a une profondeur de 1,2 µm et une concentration en porteurs de charge de 10¹⁸ cm⁻³.

11. Dispositif à semi-conducteur de puissance selon l'une quelconque des revendications précédentes, caractérisé en ce que la couche d'arrêt (7) a une profondeur de plus de 30 µm et une concentration de porteurs de charge de plus de 3*10¹⁶ cm⁻³.
